# EUROPÄISCHE PATENTSCHRIFT

(11) **EP 1 414 283 B1**
(45) Veröffentlichungstag und Bekanntmachung des Hinweises auf die Patenterteilung: **20.07.2011**
(21) Anmeldenummer: 03023416.5
(22) Anmeldetag: 17.10.2003
(51) Int. Cl.: H05K 7/14, H02B 1/052, H02B 1/056, H01R 9/26

(54) **Elektronische Steuereinrichtung mit Mitteln zur Ableitung von Störsignalen**
Control device with means for suppressing interference signals
Système de controle muni de moyens de suppression de signaux d'interférence

(30) Priorität: 26.10.2002 DE 10249981
(43) Veröffentlichungstag der Anmeldung: 28.04.2004
(73) Patentinhaber: Eaton Industries GmbH, 53115 Bonn (DE)
(72) Erfinder: Küpper, Wilfried, 53474 Bad Neuenahr (DE); Messer, Mario, 53227 Bonn (DE)

(56) Entgegenhaltungen:
- EP-A- 0 236 711
- DE-A- 4 402 001
- DE-U- 9 411 323
- US-A- 5 741 142
- US-A- 5 961 335
- US-A1- 2002 127 895
- US-B1- 6 392 319

## Beschreibung

Die Erfindung betrifft eine elektronische Steuereinrichtung mit Mitteln zur Ableitung von Störsignalen nach dem Oberbegriff von Anspruch 1.

Elektronischen Steuereinrichtungen, insbesondere SPS oder SPS-Module, rufen durch die Verarbeitung digitaler bzw. impulsförmiger Signale Störspannungen und Störströme hervor. Elektronischer Einrichtungen können durch derartige Störsignale in ihrer Funktion empfindlich gestört. Daher wurde in der Vergangenheit nach Maßnahmen gesucht, welche sowohl die Abgabe bzw. die Aufnahme von elektromagnetischen und/oder elektrostatischen Störsignalen verringern.

Eine elektrische Baueinheit nach DE 94 02 599 U1 weist ein federnde Biegestabelemente auf, die innerhalb der Baueinheit mit einer Leiterplatte elektrisch verbunden sind und mit Kontaktenden vom Boden abragen. Die Baueinheit ist auf eine Zwischenschiene zu montieren, welche Anschlusselemente aufweist, die mit den Kontaktenden kontaktieren. Über die Zwischen wird die Baueinheit auf der Tragschiene montiert. Die DE 86 01 687 U1 zeigt eine Schutzleiteranschlussklemme, die bodenseitig in einem Reihenklemmengehäuse gelagert ist und aus zwei annähernd S-förmig entgegengesetzt gebogenen federnden Hälften besteht, die beim Aufsetzen des Bodens des Reihenklemmengehäuses auf eine Tragschiene in Kontakt mit jeweils einem Rand der Tragschiene treten. Die Schutzleiteranschlussklemme ist in der Weise unsymmetrisch ausgebildet, dass sie gleichzeitig der elastische Halterung des Gehäuses auf der Tragschiene dient. Die DE 691 06 741 T2 zeigt ebenfalls ein federndes Kontaktelement, das beim Aufsetzen des zugehörigen Anschlussblocks auf eine Tragschiene in Kontakt mit einem Rand der Tragschiene gelangt.

Die vorstehend beschriebenen Ableitmittel lassen sich allerdings nicht auf elektronische Steuereinrichtungen übertragen, die Steuermodule enthalten, die über wenigstens ein Montagemodul elektrisch und mechanisch miteinander verbunden werden. Rückseitig weisen derartige Steuermodule und vorderseitig derartige Montagemodule sowohl elektrische Steckvorrichtungen als auch mechanische Rastvorrichtungen auf, die beim Aufsetzen der Steuermodule auf die Montagemodule in elektrische bzw. mechanische Verbindung treten. Eine Weiterbildung besteht darin, dass mehrere Montagemodule wiederum über elektrische Steckvorrichtungen sowie über mechanische Rastvorrichtungen seitlich verbunden bzw. angereiht werden können.

Aus DE 199 64 156 A1 ist eine elektronische Steuereinrichtung mit Mitteln zur Ableitung von Störsignalen bekannt, die rückseitige Schnappmittel zur Befestigung auf einer Tragschiene und ein Ableitblech aufweist, das mit einem Federarm aus einer zur Aufnahme der Tragschiene dienenden rückseitigen Ausnehmung ragt, mit dem über einen im Bereich einer Begrenzung der Ausnehmung befindlichen Kontaktbereich mit der Tragschiene kontaktierbar ist und das mit einer im Inneren der Steuereinrichtung festgelegten Leiterplatte über einen mit dieser mechanisch und elektrisch verbundenen Kontakt in elektrischer Verbindung steht. Die Steuereinrichtung ist aus wenigstens einem Steuermodul und einem Montagemodul zusammengesetzt, wobei das Steuermodul aus einem Modulgehäuse und der darin befestigten Leiterplatte besteht und das Montagemodul vorderseitig mit dem Steuermodul elektrisch sowie mechanisch verbunden, rückseitig mit den Schnappmitteln sowie der Ausnehmung ausgestattet und mit einer der Anzahl der steckbaren Steuermodule zugeordneten Anzahl von Ableitblechen versehen ist. Das Ableitblech ist mit einem Federarm versehen, der zur Kontaktierung der Tragschiene dient.

Die vorgenannten Ableit- bzw. Kontaktmittel sind lediglich für die Montage auf einer Tragschiene geeignet.

Ein Elektronik-Gehäuse nach DE 94 11 323 U1 besitzt zum einen rückseitige Mittel zur Schnappbefestigung auf einer im Querschnitt hutförmigen Tragschiene und zum anderen Mittel zur Schraubbefestigung auf einer ebenen Tragplatte. Zur Aufnahme der Tragschiene ist an der Rückwand der Einrichtung eine Ausnehmung ausgebildet. Innerhalb der Ausnehmung ist ein Ableitblech angenietet, das bezüglich der Längsachse der Ausnehmung doppelarmig ausgebildet ist und mit je einem der Federarme quer durch die Begrenzung der Ausnehmung ragt, wobei die Federarme im unbelasteten Zustand leicht von der Rückwand abgebogen sind. Über einen im Grenzbereich der Ausnehmung befindlichen ersten Kontaktbereich treten die Federarme beim Aufsetzen auf eine geerdete Tragschiene mit dieser in Kontakt. Über einen endseitigen, außerhalb der Ausnehmung befindlichen Z-förmig gebogenen, zweiten Kontaktbereich treten die Federarme beim Aufsetzen auf eine geerdete Tragplatte mit dieser in Kontakt. Das Ableitblech ragt mit Kontaktstegen durch die Rückwand ins Innere der Einrichtung. Die Kontaktstege sind endseitig jeweils mit zwei gegenüberstehenden Federklemmen ausgebildet. Ein zwischen ein Federklemmenpaar eingeführtes Kontaktmesser bildet das freie Ende eines Kontaktwinkels, der mechanisch auf einer im Inneren der Einrichtung festgelegten Leiterplatte befestigt und dabei elektrisch mit einem für die Ableitung der auf der Leiterplatte auftretenden Störsignale maßgeblichen Leiterzug verbunden ist.

Der Erfindung liegt die Aufgabe zugrunde, bei mit Montagemodulen verbundenen Steuermodulen sowohl die Verträglichkeit gegen äußere Störsignale zu verbessern als auch die Abgabe von internen Störsignalen an die Umgebung zu verringern.

Ausgehend von elektronischen Steuereinrichtungen der eingangs genannten Art wird die Aufgabe erfindungsgemäß durch die Merkmale des unabhängigen Anspruches gelöst, während den abhängigen Ansprüchen vorteilhafte Weiterbildungen der Erfindung zu entnehmen sind.

In dem Montagemodul ist jedem vorgesehenen Steckplatz für ein Steuermodul ein Ableitblech mit zwei Federarmen vorgesehen. Einerseits wird bei der Montage des betreffenden Steuermoduls auf dem Montagemodul die innere Elektronik des Steuermoduls über einen am Steuermodul angeordneten Federwinkel mit dem zweiten Federarm des zugehörigen Ableitbleches verbunden. Anderseits kontaktiert bei der Befestigung der so aus mindestens einem Steuermodul und der Tragplatte zusammengesetzten Steuereinrichtung auf einer Tragschiene oder auf einer Tragplatte der erste Federarm mit der Tragschiene bzw. der Tragplatte. Sowohl die Kontaktierung zur inneren Elektronik als auch die Kontaktierung zur Tragschiene bzw. Tragplatte bedarf keiner zusätzlich zu verwendenden Verbindungsteile als auch keines weiteren Hinzutuns des Montagepersonals.

Eine vorteilhafte Weiterbildung besteht in der Anordnung des ersten Federarmes gegenüber nur mit einem Rand der Tragschiene zusammenwirkenden Schnappmitteln, insbesondere eines Schnappschiebers, wodurch ein hoher Kontaktdruck zwischen dem ersten Federarm und dem betreffenden Randbereich der Tragschiene erreicht wird.

Zweckmäßige Weiterbildungen bestehen in einer gewölbten Ausbildung des zweiten Kontaktbereichs des ersten Federarms gegenüber einer Tragplatte, in einer U-förmig zurückgebogenen Ausbildung des dritten Kontaktbereichs des zweiten Federarms gegenüber dem Federwinkel und in einer U-förmig zurückgebogenen Ausbildung des vierten Kontaktbereichs des Federwinkels gegenüber dem zweiten Federarm.

Eine vorteilhafte Weiterbildung zur Gewährleistung einer zuverlässigen Verbindung ins Innere des Steuermoduls besteht in der Festlegung des Federwinkels und gleichzeitigen Verbindung, insbesondere durch eine Schraubverbindung, mit dem Kontaktwinkel der mit Störsignalen behafteten Leiterplatte in einer rückseitigen Ausformung des Steuermoduls.

Weitere Einzelheiten und Vorteile der Erfindung ergeben sich aus dem folgenden, anhand von Figuren erläuterten Ausführungsbeispiel. Es zeigen
- Figur 1:: die geschnittene Seitenansicht einer erfindungsgemäßen Steuereinrichtung im Zustand der Montage;
- Figur 2:: die Einzelheit II aus Fig. 1;
- Figur 3:: die Rückansicht der auf einer Tragschiene montierten Steuereinrichtung;
- Figur 4:: in perspektivischer Darstellung das Montagemodul der Steuereinrichtung aus Fig. 3;
- Figur 5:: das Montagemodul aus Fig. 4 bei abgenommener Verbindungsplatte.

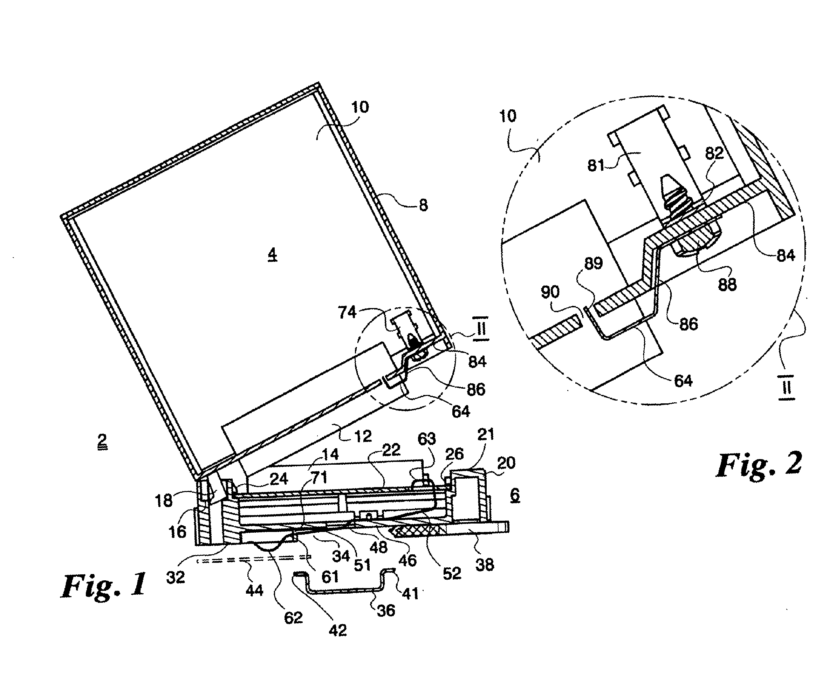

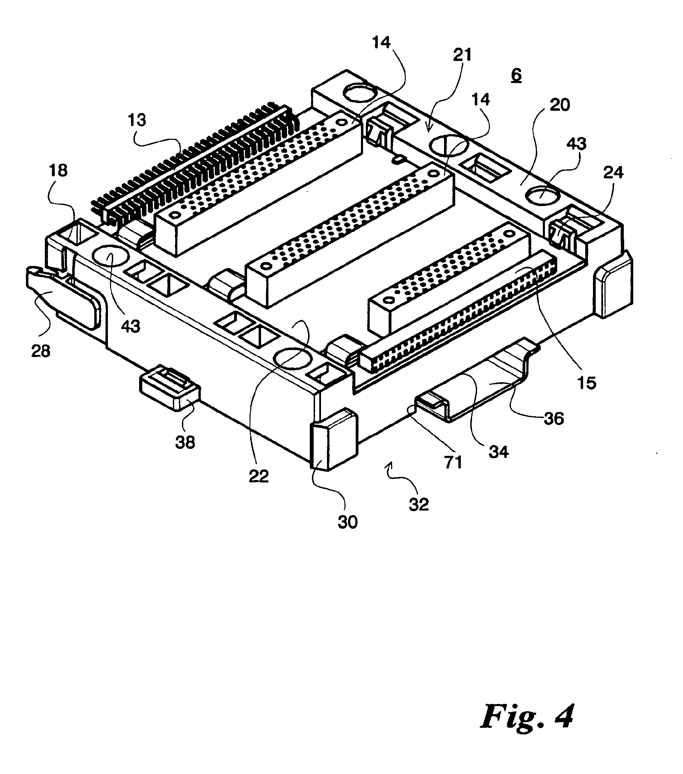

Nach Fig. 1 besteht die Steuereinrichtung 2 aus wenigstens einem Steuermodul 4 und einem Montagemodul 6. Im Falle mehrerer Steuermodule 4 sind diese auf dem Montagemodul 6 gemäß der Darstellung in Fig. 1 parallel zur Zeichenebene hintereinander angeordnet. Das Steuermodul 4 ist von einem Modulgehäuse 8 umgeben, in dem eine Leiterplatte 10 festgelegt ist. Am unteren Rand der Leiterplatte 10 ist eine Steckerleiste 12 montiert, die rückseitig aus dem Modulgehäuse 8 ragt und beim Aufsetzen des Steuermoduls 4 auf das Montagemodul 6 mit einer dort befestigten Buchsenleiste 14 verbunden wird. Am Montagemodul 6 und an den Steuermodulen 4 sind zusätzlich zur gegenseitigen mechanischen Befestigung in an sich bekannter Weise teilweise hakenförmige Befestigungsmittel 16, 18 vorgesehen (siehe auch Fig. 4).

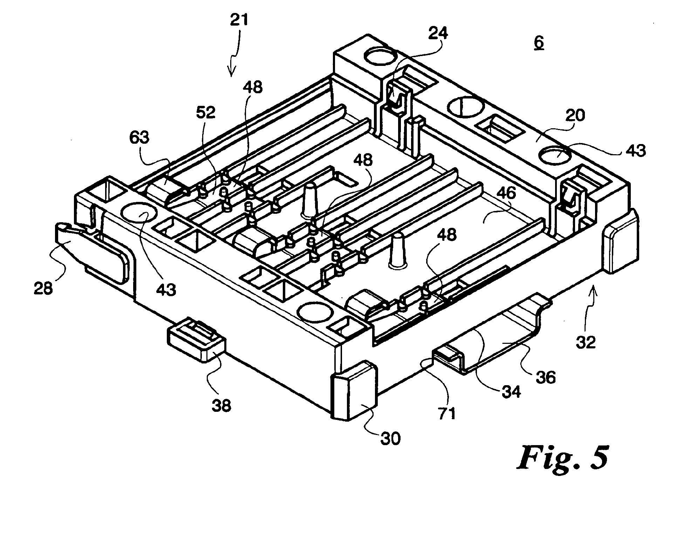

Nach Fig. 1, Fig. 4 und Fig. 5 besteht das Montagemodul 6 aus einem plattenartigen Grundkörper 20, von dessen Vorderseite 21 eine Verbindungsplatte 22 mithilfe von am Grundkörper 20 angeformten Rastnasen 24 und Vorsprüngen 26 eingeklipst ist. Mit der Verbindungsplatte 22 sind mehrere Buchsenleisten 14 zur Aufnahme der Steckerleisten 12 von bis zu drei Steuermodulen 4 mechanisch und elektrisch verbunden.

Die Verbindungsplatte 22 ist seitlich mit einer zusätzlichen Steckerleiste 13 und gegenüberstehend einer zusätzlichen Buchsenleiste 15 versehen, um mehrere derartige Montagemodule 6 nebeneinander zu reihen. Dem gleichen Zwecke dienen seitlich überstehenden mechanischen Rastmittel 28 und 30 an dem Grundkörper 20.

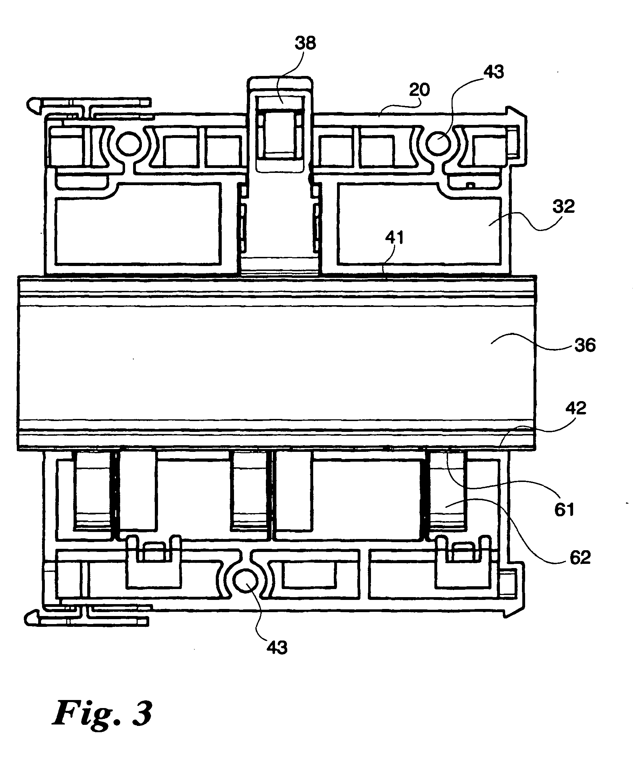

Wie insbesondere aus Fig. 1 und Fig. 3 zu ersehen ist, ist auf der Rückseite 32 des Grundkörpers 20 eine Ausnehmung 34 ausgebildet, die eine Tragschiene 36 aufnehmen kann. Beim Montieren der Steuereinrichtung 2 auf die Tragschiene 36 hintergreift in bekannter Weise ein in der Rückseite 32 verschieblich gelagertes Schnappmittel 38 in Form eines federbeaufschlagten Schnapphakens eine erste Außenkante 41 der Tragschiene 36. In dem Grundkörper 20 sind weiterhin Bohrungen 43 als Teil von Schraubverbindungsmitteln ausgespart, damit die Steuereinrichtung 2 alternativ auf eine in Fig. 1 nur zum Teil angedeutete Tragplatte 44 montiert werden kann.

Im Boden 46 des Grundkörpers 20 ist eine der Anzahl der Buchsenleisten 14 entsprechende Anzahl von Ableitblechen 48 festgelegt. Die Ableitbleche 48 bestehen aus elektrisch leitendem Federmaterial und weisen jeweils zwei gegenüberstehende Federarme 51 und 52 auf.

Der erste Federarm 51 ist im unbeaufschlagten Zustand leicht von der Rückseite 32 abgewinkelt und erstreckt sich sowohl innerhalb der Ausnehmung 34 als auch durch deren erste Begrenzung 71 gehend darüber hinaus. Die erste Begrenzung 71 verläuft parallel zur zweiten Außenkante 42 der Tragschiene 36 und ist gegenüber dem Schnappmittel 38 angeordnet. Der erste Federarm 51 weist im Bereich der ersten Begrenzung 71 einen ersten Kontaktbereich 61 auf, der bei Montage der Steuereinrichtung 2 auf die Tragschiene 36 in Kontakt mit der zweiten Außenkante 42 der Tragschiene 36 gelangt. Außerhalb der Ausnehmung 34 bildet der Endbereich des ersten Federarms 51 einen zur Rückseite 32 aufgewölbten zweiten Kontaktbereich 62, der bei Montage der Steuereinrichtung 2 auf die Tragplatte 44 in elektrischen Kontakt mit der Oberfläche der Tragplatte 44 gelangt.

Der zweite Federarm 52 verläuft im unbeaufschlagten Zustand leicht vom Boden 46 zur Vorderseite 21 abgewinkelt und endet in einem zur Rückseite 32 zurückgebogenen U-förmigen dritten Kontaktbereich 63.

Wie insbesondere aus Fig. 1 und Fig. 2 zu ersehen ist, ist in dem der Steckerleiste 12 benachbarten Bereich der Leiterplatte 10 ein erster Schenkel 81 eines metallischen, rechtwinklig gebogenen Kontaktwinkels 74 aufgelötet und mit einem Leiterzug oder einer Leiterfläche der Leiterplatte 10 verbunden, der bzw. die besonders gut zur Ableitung von Störspannungen bzw. Störströmen geeignet ist. Der zweite Schenkel 82 des Kontaktwinkels 74 liegt an der Gegenseite einer Ausformung 84 an, die in das Modulgehäuse 8 eintretend und annähernd dem dritten Kontaktbereich 63 gegenüberliegend am Modulgehäuse 8 ausgebildet ist. In der Ausformung 84 liegt ein Federwinkel 86 und ist über eine Schraubverbindung 88, die eine durch eine in der Ausformung 84 vorgesehene Bohrung reichende Schraube aufweist, mit dem Kontaktwinkel 74 verbunden. Die Federwinkel 86 ist zu einem gegenüber der Vorderseite 21 des Montagemoduls U-förmig zurückgebogenen, vierten Kontaktbereich 64 ausgebildet und reicht an seinem freien Ende 89 durch eine Öffnung 90 im Modulgehäuse 8. Beim Aufsetzen des Steuermoduls 4 auf eine der im Montagemodul 6 vorgesehenen Steckplätze gelangt der vierte Kontaktbereich 64 in Kontakt mit dem dritten Kontaktbereich 63 des zugehörigen Ableitbleches 48, wobei das freie Ende 90 tiefer in die Öffnung 90 dringt.

Nach der Montage der Steuereinrichtung 2 auf die Tragschiene 36 oder auf die Tragplatte 44 besteht zur Erdableitung von Störsignalen eine durchgängige leitende Verbindung von der Leiterplatte 10 des betreffenden Steuermoduls 4 über den Kontaktwinkel 74 zum Federwinkel 86, vom vierten Kontaktbereich 64 des Federwinkels 86 zum dritten Kontaktbereich 63 des zum zugehörigen Ableitblech 48 gehörenden zweiten Federarms 52, von dort zum zweiten Federarm 51 des Ableitbleches 48 und schließlich vom ersten oder zweiten Kontaktbereich 61 bzw. 62 zur Tragschiene 36 bzw. Tragplatte 44. Diese durchgehende Verbindung entsteht ohne zusätzliche Mittel und Arbeitsgänge bei der Montage der Steuereinrichtung 2.

## Patentansprüche

1. Elektronische Steuereinrichtung mit Mitteln zur Ableitung von Störsignalen,
- mit rückseitigen Schnappmitteln (38) und mit Schraubverbindungsmitteln (43) zur wahlweisen Befestigung auf einer Tragschiene (36) bzw. einer Tragplatte (44), wobei die Rückseite der Steuereinrichtung (2) im montierten Zustand zur Tragschiene (36) bzw. Tragplatte (44) weist, und
- mit wenigstens einem Ableitblech (48), das mit einem Federarm (51) annähernd parallel zur Rückseite der Steuereinrichtung (2) aus einer zur Aufnahme der Tragschiene (36) dienenden Ausnehmung (34) ragt, einen im Bereich einer Begrenzung (71) der Ausnehmung (34) befindlichen, ersten Kontaktbereich (61) zur Kontaktierung mit der Tragschiene (36) und einen endseitigen, außerhalb der Ausnehmung (34) befindlichen, zweiten Kontaktbereich (62) zur Kontaktierung mit der Tragplatte (44) aufweist und mit wenigstens einer im Inneren der Steuereinrichtung (2) festgelegten Leiterplatte (10) über einen mit dieser mechanisch und elektrisch verbundenen Kontaktwinkel (74) in elektrischer Verbindung steht,
**dadurch gekennzeichnet,**
- **dass** die Steuereinrichtung (2) aus wenigstens einem Steuermodul (4) und einem Montagemodul (6) zusammengesetzt ist, wobei das Steuermodul (4) aus einem Modulgehäuse (8) und der wenigstens einen darin festgelegten Leiterplatte (10) besteht und das Montagemodul (6) mit seiner von der Rückseite der Steuereinrichtung (2) abgewandten Vorderseite (21) mit dem Steuermodul (4) elektrisch sowie mechanisch verbunden, auf seiner mit der Rückseite der Steuereinrichtung (2) zusammenfallenden Rückseite (32) mit den Schnappmitteln (38) sowie der Ausnehmung (34) ausgestattet und mit einer der Anzahl der steckbaren Steuermodule (4) zugeordneten Anzahl von Ableitblechen (48) versehen ist,
- **dass** das wenigstens eine Ableitblech (48) mit zwei unterschiedlichen Federarmen (51, 52) versehen ist, wobei der erste Federarm (51) den ersten und den zweiten Kontaktbereich (61, 62) aufweist, der zweite Federarm (52) endseitig einen zum Steuermodul (4) weisenden, dritten Kontaktbereich (63) bildet, und zwischen beiden Federarmen (51, 52) in dem Montagemodul (6) festgelegt ist, und
- **dass** der Kontaktwinkel (74) mit einem Federwinkel (86) verbunden ist, der in Richtung zum Montagemodul (6) vom Modulgehäuse (8) absteht und einen vierten Kontaktbereich (64) bildet, der mit dem dritten Kontaktbereich (63) kontaktiert.

2. Steuereinrichtung nach vorstehendem Anspruch, **dadurch gekennzeichnet, dass** die Schnappmittel (38) nur mit einem Rand (41) der Tragschiene (36) zusammenwirken und der erste Federarm (51) durch eine den Schnappmitteln (38) gegenüberliegende erste Begrenzung (71) der Ausnehmung (34) ragt.

3. Steuereinrichtung nach einem der vorstehenden Ansprüche, **dadurch gekennzeichnet, dass** der zweite Kontaktbereich (62) bezüglich der Rückseite (32) des Montagemoduls (6) aufgewölbt ist.

4. Steuereinrichtung nach einem der vorstehenden Ansprüche, **dadurch gekennzeichnet, dass** der dritte Kontaktbereich (63) U-förmig zur Rückseite (32) des Montagemoduls (6) zurückgebogen ist.

5. Steuereinrichtung nach einem der vorstehenden Ansprüche, **dadurch gekennzeichnet, dass** der vierte Kontaktbereich (64) U-förmig gegenüber der Vorderseite (21) des Montagemoduls (6) zurückgebogen ist.

6. Steuereinrichtung nach einem der vorstehenden Ansprüche, **dadurch gekennzeichnet, dass** an dem Modulgehäuse (8), gegenüber der Vorderseite (21) des Montagemoduls (6) eine zurücktretende Ausformung (84) ausgebildet ist, in welcher der Federwinkel (86) einliegt und mit dem von der Gegenseite an die Ausformung (84) reichenden Kontaktwinkel (74) verbunden ist.

7. Steuereinrichtung nach vorstehendem Anspruch, **dadurch gekennzeichnet, dass** zwischen dem Federwinkel (86) und dem Kontaktwinkel (74) eine Schraubverbindung (88) besteht.

## Claims

1. Electronic control device comprising means for diverting interference signals,
- comprising rear snap-in means (38) and comprising screw connection means (43) for selective fixing to a carrier rail (36) and a carrier plate (44) respectively, the rear face of the control device (2) facing towards the carrier rail (36) and carrier plate (44), respectively, when mounted, and
- at least one diversion plate (48), projecting by a spring arm (51) approximately parallel to the rear face of the control device (2) from a clearance (34) for receiving the carrier rail (36), comprising a first contact region (61), located in the region of a border (71) of the clearance (34), for contacting the carrier rail (36), and a second, end-face contact region (62), located outside the clearance (34), for contacting the carrier plate (44), and electrically connected to at least one circuit board (10), fixed inside the control device (2), via a contact bracket (74) which is mechanically and electrically fixed thereto,
**characterised in that**
- the control device (2) is composed of at least one control module (4) and a mounting module (6), the control module (4) consisting of a module housing (8) and the at least one circuit board (10) fixed therein, and the mounting module (6) being electrically and mechanically connected, by the front face (21) thereof remote from the rear face of the control device (2), to the control module (4), and being equipped, on the rear face (32) thereof coinciding with the rear face of the control device (2), with the snap-in means (38) and the clearance (34), and being provided with a number of diversion plates (48) associated with the number of pluggable control modules (4),
- the at least one diversion plate (48) is provided with two different spring arms (51, 52), the first spring arm (51) comprising the first and the second contact region (61, 62), and the second spring arm (52) forming at the end face a third contact region (63) facing towards the control module (4), and is fixed between the two spring arms (51, 52) in the mounting module (6), and
- the contact bracket (74) is connected to a spring bracket (86), which projects from the module housing (8) towards the mounting module (6) and forms a fourth contact region (64), which contacts the third contact region (63).

2. Control device according to the preceding claim, **characterised in that** the snap-in means (38) only cooperate with one edge (41) of the carrier rail (36), and the first spring arm (51) projects through a first border (71), opposite the snap-in means (38), of the clearance (34).

3. Control device according to either of the preceding claims, **characterised in that** the second contact region (62) is arched relative to the rear face (32) of the mounting module (6).

4. Control device according to any one of the preceding claims, **characterised in that** the third contact region (63) is bent back in a U-shape relative to the rear face (32) of the mounting module (6)

5. Control means according to any one of the preceding claims, **characterised in that** the fourth contact region (64) is bent back in a U-shape relative to the front face (21) of the mounting module (6).

6. Control means according to any one of the preceding claims, **characterised in that** a cavity (84), which is recessed relative to the front face (21) of the mounting module (6), and in which the spring bracket (86) lies and is connected to the contact bracket (74) extending from the counter face to the cavity (84), is formed on the module housing (8).

7. Control device according to the preceding claim, **characterised in that** there is a screw connection (88) between the spring bracket (86) and the contact bracket (74).

## Revendications

1. Dispositif de commande électronique, comportant des moyens pour supprimer les signaux parasites ;
- comportant des moyens d'encliquetage arrière (38) et des moyens d'assemblage par vis (43), en vue d'une fixation sélective sur un rail de support (36) ou une plaque de support (44), le côté arrière du dispositif de commande (2) étant orienté dans l'état monté vers le rail de support (36) ou vers la plaque de support (44) ; et
- comportant au moins une tôle de déviation (48), débordant avec un bras de ressort (51) de manière pratiquement parallèle au côté arrière du dispositif de commande (2) à partir d'un évidement (34) servant à recevoir le rail de support (36), une première région de contact (61), agencée dans la zone d'une limitation (71) de l'évidement (34), destinée à contacter le rail de support (36), et une deuxième région de contact (62), agencée sur le côté d'extrémité, hors de l'évidement (34), destinée à contacter la plaque de support (44), et au moins une carte de circuit imprimé (10) fixée dans l'intérieur du dispositif de commande (2), en communication électrique avec celui-ci par l'intermédiaire d'un angle de contact (74) à liaison mécanique et électrique ;
**caractérisé en ce que**
- le dispositif de commande (2) comprend au moins un module de commande (4) et un module de montage (6), le module de commande (4) comprenant un boîtier de module (8) et la au moins une carte de circuit imprimé (10) qui y est fixée, le module de montage (6) étant relié de manière électrique et mécanique au module de commande (2) avec son côté avant (21) opposé au côté arrière du dispositif de commande (2), comportant sur son côté arrière (32) coïncidant avec le côté arrière du dispositif de commande (2) les moyens d'encliquetage (38) et l'évidement (34), et comportant un nombre de tôles de déviation (48) correspondant au nombre des modules de commande enfichables (4) ;
- **en ce que** la au moins une tôle de déviation (48) comporte deux bras de ressort différents (51, 52), le premier bras de ressort (51) comportant les première et deuxième régions de contact (61, 62), le deuxième bras de ressort (52) formant sur son côté d'extrémité une troisième région de contact (63) orientée vers le module de commande (4), et fixée entre les deux bras de ressort (51, 52) dans le module de montage (6) ;
- **en ce que** l'angle de contact (74) est relié à un angle de ressort (86), débordant du boîtier de module (8) dans la direction du module de montage (6) et formant une quatrième région de contact (64), en contact avec la troisième région de contact (63).

2. Dispositif de commande selon la revendication précédente, **caractérisé en ce que** les moyens d'encliquetage (38) coopèrent uniquement avec un bord (41) du rail de support (36), le premier bras de ressort (51) débordant à travers une première limitation (71) de l'évidement (34) opposée aux moyens d'encliquetage (38).

3. Dispositif de commande selon l'une des revendications précédentes, **caractérisé en ce que** la deuxième région de contact (62) est bombée par rapport au côté arrière (32) du module de montage (6).

4. Dispositif de commande selon l'une des revendications précédentes, **caractérisé en ce que** la troisième région de contact (63) est repliée en U vers le côté arrière (32) du module de montage (6).

5. Dispositif de commande selon l'une des revendications précédentes, **caractérisé en ce que** la quatrième région de contact (64) est repliée en U par rapport au côté avant (21) du module de montage (6).

6. Dispositif de commande selon l'une des revendications précédentes, **caractérisé en ce que** le boîtier de module (8) comporte une formation en retrait (84) par rapport au côté avant (21) du module de montage (6), dans laquelle est inséré l'angle de ressort (86) et reliée à l'angle de contact (74) contactant la formation (84) à partir du côté opposé

7. Dispositif de commande selon la revendication précédente, **caractérisé en ce qu'**un assemblage par vis (88) est agencé entre l'angle de ressort (86) et l'angle de contact (74).
